# EUROPEAN PATENT APPLICATION

(11) **EP 4 443 497 A1**
(43) Date of publication of application: **09.10.2024**
(21) Application number: 24162733.0
(22) Date of filing: 11.03.2024
(51) Int. Cl.: H01L 23/495, H01L 21/48

(54) **SEMICONDUCTOR PACKAGE, METHOD OF MANUFACTURING A SEMICONDUCTOR DEVICE AND LEAD FRAME**

(30) Priority: 22.03.2023 CN 202310283643
(71) Applicant: NXP USA, Inc., Austin TX 78735 (US)
(72) Inventor: Song, Jian, 5656AG Eindhoven (NL); Li, Jun, 5656AG Eindhoven (NL)
(74) Representative: Hardingham, Christopher Mark

(57) **Abstract**

A semiconductor package has top and bottom surfaces and includes a vertical direction extending from the top surface to the bottom surface. The semiconductor package comprises a semiconductor die and a lead frame. At least one of each pair of neighboring leads comprises an elongate lug extending towards the other of the pair of neighboring leads. A region of each lug remote from the lead has a thickness which is smaller than a full thickness of the lead frame. The semiconductor package further comprising molding compound encapsulating the semiconductor die and forming the semiconductor package. The molding compound fills the spaces between the leads and fills spaces separating the die pad from the leads.

## Description

### BACKGROUND

The present invention relates to a semiconductor package, to a method of manufacturing a semiconductor device and to a lead frame for use with the semiconductor package.

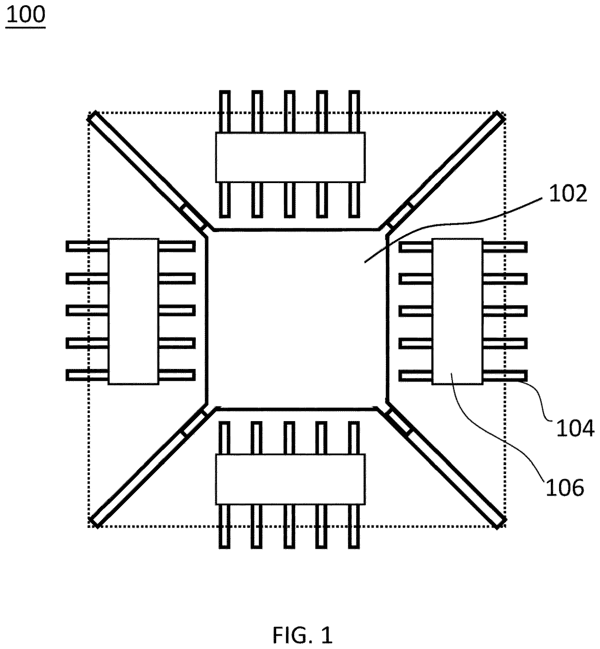

FIG.1 is a schematic top plan view of a lead frame 100 used to assemble a semiconductor device. The lead frame 100 comprises a generally rectangular die pad 102 surrounded by a plurality of leads 104. Relative to their length, the leads 104 are very close to one another. To prevent the leads 104 from bending or contacting with adjacent leads during assembly, tape 106 is placed over the inner area leads to hold the leads 104 in place. The tape 106 may be adhesive tape. When lead frame is vibrated by external force, the adhesive tape may make the lead relatively fixed and reduce the influence during the process of wire bonding. However, in some cases, lead frame cannot be supported by the adhesive tape because the lead frame does not have enough space for the adhesive tape. Then, the leads on the lead frame may vibrate or shift which may cause a wire loop issue. Such wire loop issues may include wire short, wire open and wire sway.

Thus, it would be desirable to have a semiconductor package or a lead frame, which does not suffer to such an extent from such wire loop issues.

### SUMMARY

This summary is provided to introduce a selection of concepts in a simplified form that are further described below in the Detailed Description. This summary is not intended to be relied on to identify key features or essential features of the claimed subject matter, nor is it intended to be used to limit the scope of the claimed subject matter.

According to a first aspect, there is a semiconductor package having top and bottom surfaces and including a vertical direction extending from the top surface to the bottom surface. The semiconductor package comprises a semiconductor die; a lead frame comprising a die-pad having four sides and a plurality of leads having spaces therebetween and around the four sides of the die-pad, spaced apart therefrom and electrically isolated therefrom. The plurality of leads comprises a plurality of first leads and a plurality of second leads. The plurality of second leads are interleaved with the plurality of first leads, and offset therefrom in the vertical direction. The semiconductor die is attached to an upper or first surface of the die pad. At least one of any pair of neighboring leads comprises an elongate lugs extending towards the other of the pair of neighboring leads. Each of the lugs has a thickness which is smaller than a full thickness of the lead frame. The semiconductor package further comprises molding compound encapsulating the semiconductor die and forming the semiconductor package. The molding compound fills the spaces between the leads and fills spaces separating the die pad from the leads.

According to a second aspect, there is a method of manufacturing a packaged semiconductor device. The method comprises the steps of: providing a lead frame comprising a die pad having four sides and a plurality of leads having spaces therebetween and around the four sides of the die pad, wherein the plurality of leads comprises a plurality of first leads and a plurality of second leads interleaved with the plurality of first leads, wherein neighboring leads of the plurality of leads are connected by a beam at inner lead areas of the first lead and the second lead; mounting a semiconductor die on the die pad; electrically connecting bonding pads disposed on a top surface of the semiconductor die with respective ones of the plurality of first and second leads; using a molding tool, deforming the lead frame to: (i)break each of the beams to form a respective at least one elongate lug, wherein each broken lug has a thickness which is smaller than a full thickness of the lead frame; (ii)displace at least some of the leads to form a vertical offset between the plurality of second leads and the plurality of first leads; and injecting molding compound into the molding tool to encapsulate the semiconductor die and form the package, wherein the molding compound fills spaces between the leads, and between the leads and the die-pad.

According to a third aspect, there is lead frame for using in a semiconductor device including a vertical direction extending from a top surface to a bottom surface. The lead frame comprises a die pad having four sides; a plurality of leads having spaces therebetween and around the four sides of the die-pad, spaced apart therefrom and electrically isolated therefrom. At least one of each pair of neighboring leads comprises a beam extending in a first direction towards the other of the pair of neighboring leads. Each beam has a thickness which is smaller than a full thickness of the lead frame.

### BRIEF DESCRIPTION OF THE DRAWINGS

So that the manner in which the above recited features of the present application can be understood in detail, a more particular description of the application, briefly summarized above, can be had by reference to embodiments, some of which are illustrated in the appended drawings. It is to be noted, however, that the appended drawings illustrate only typical embodiments of this application and are therefore not to be considered limiting of its scope, for the application can admit to other equally effective embodiments. The drawings are for facilitating an understanding of the application and thus are not necessarily drawn to scale. Advantages of the subject matter claimed will become apparent to those skilled in the art upon reading this description in conjunction with the accompanying drawings, in which like reference numerals have been used to designate like elements, and in which:
FIG. 1 is a top plan view of a lead frame of a conventional semiconductor package;
FIG. 2A is top plan view showing a lead frame before deformation to be used for fabricating a QFP package according to one embodiment of the present invention;
FIG. 2B is a cross-section view of the lead frame of FIG. 2A along line A-A';
FIG. 3 is a top plan view showing an adhesive applying step of the lead frame;
FIG. 4 is a top plan view showing a die mounting step of the lead frame;
FIG. 5A is a top plan view showing a wire bonding step of the lead frame;
FIG. 5B is a cross-section view showing the wire bonding step;
FIG. 6A is a cross-section view showing deformation of the lead frame by a molding tool;
FIG. 6B is a cross-section view showing a lead frame after deformation;
FIG. 7A is a schematic diagram showing the first leads, the second leads and the beams of the lead frame before deformation;
FIG. 7B is a schematic diagram showing the first leads, the second leads and the elongate lugs after deformation;
FIG. 7C is an enlarged sideways sectional view, along line B-B' of FIG. 2A, of a first leads, a neighboring second lead and the beam of the lead frame before deformation according to one embodiment of the invention;
FIG. 7D is an enlarged top plan view of the first leads, a neighboring second lead and the beam of FIG. 7C before deformation according to one embodiment of the invention;
FIG. 7E is an enlarged sideways sectional view of a first lead, a neighboring second lead and an elongate lug after deformation;
FIG. 7F is an enlarged sideways sectional view, along line B-B' of FIG. 2A, of a first lead, a neighboring second lead and the beam of the lead frame before deformation according to another embodiment of the invention;
FIG. 7G is an enlarged top plan view of a first lead, a neighboring second lead and an elongate lug of FIG. 7F before deformation according to an embodiment of the invention;
FIG. 7H is an enlarged sideways sectional view of a first lead, a neighboring second lead and an elongate lug after deformation;
FIG. 8 is a cross-section view showing a semiconductor package using the lead frame according to one embodiment of the present invention;
FIG. 9 is a cross-section view showing a semiconductor package according to one embodiment of the present invention.

### DETAILED DESCRIPTION

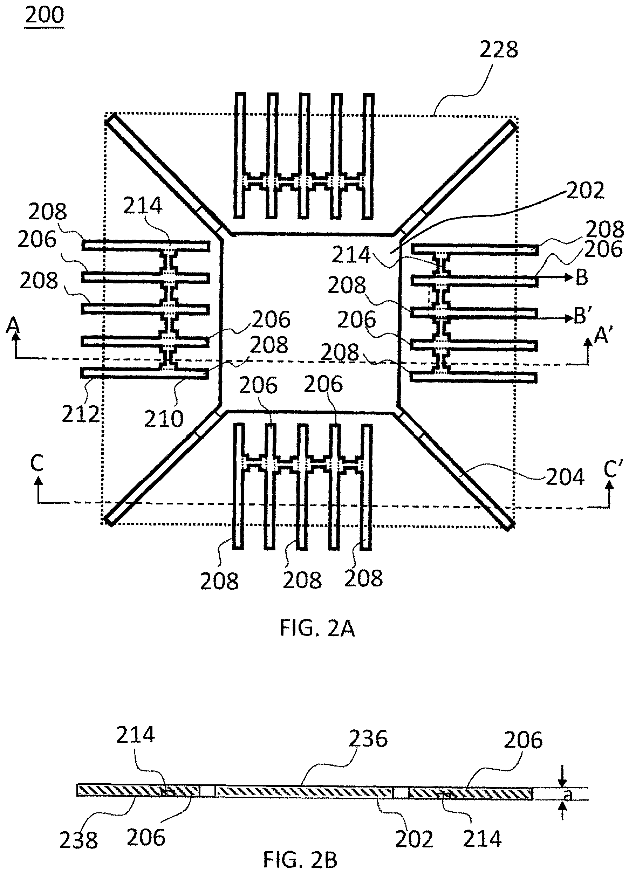

FIG.2A is a top plan view showing a lead frame before deformation to be used for fabricating a QFP package according to one embodiment of the present invention. FIG. 2B is a cross-section view of the lead frame of FIG. 2A along line A-A'.

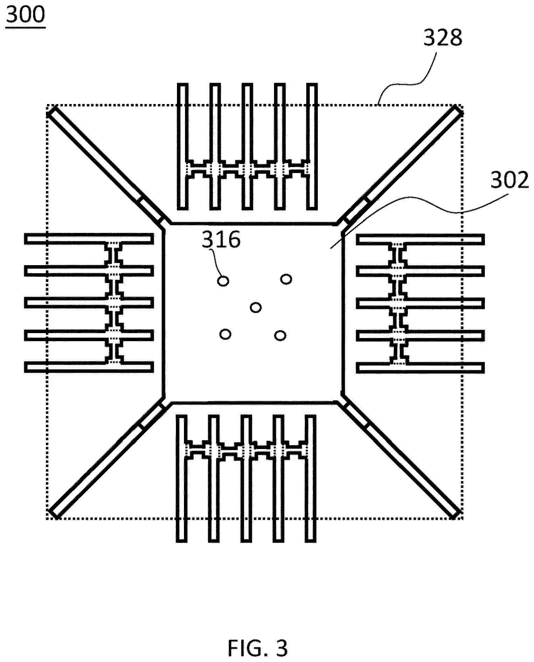

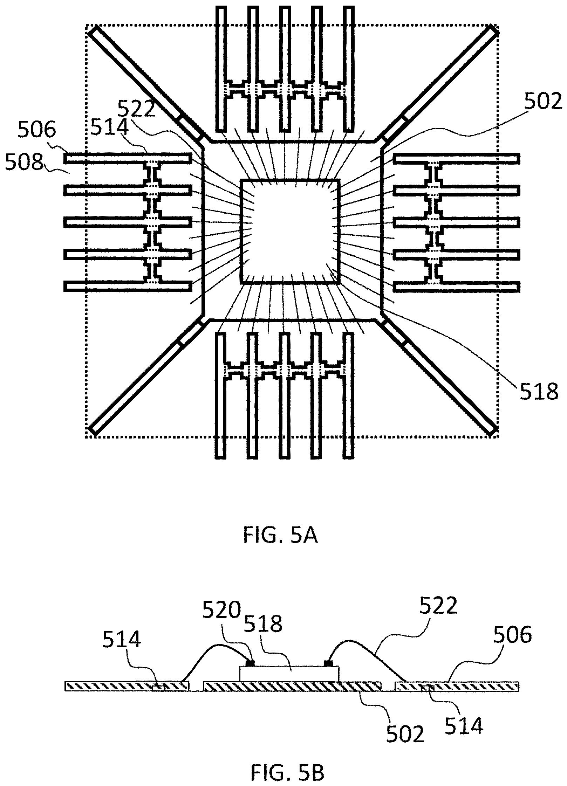

Referring now to FIG. 2A and FIG. 2B, a lead frame 200 comprises a first surface 236, a second surface 238 and a full thickness 'a' between the first surface 236 and the second surface 238. The lead frame 200 is formed at its central portion with a die pad 202 which has four sides for mounting a semiconductor die (see FIG.3), which is formed with a semiconductor circuit and bonding pads (see FIG. 5B) on its top surface. The die pad 202 is supported by four tie bars 204.

A plurality of first leads 206 and a plurality of second leads 208 surround the four sides of the die pad 202. Each of the pluralities of first leads 206 and second leads 208 has an inner lead area 210 proximate to the die pad 202 and an outer lead area 212 extending outwardly from the inner lead area 210. The plurality of second leads 208 are interleaved with the plurality of first leads 206. The dimensions of the first leads may be the same as the second leads (as shown in FIG. 2A) or may be different. In particular, the length of the first leads may be different to the length of the second leads. As will be more apparent hereinunder, at least one of the first leads and second leads may be deformed during manufacture. For packaged devices in which it is required or desirable that the leads protrude a uniform amount beyond the molding compound, and a one of the first leads and the second leads are deformed to a greater extent than the other of the first leads and the second leads, it may be appropriate that a one of the first leads and the second leads which is deformed, or is deformed to a greater extent, is longer.

The lead frame 200 may be formed by pressing, stamping or other techniques, with which the skilled person will be familiar. However, it may be etched and thus may also be referred to as an etched lead frame. At least part of the beam or elongate lug 214 extending in a first direction from at least one of any pair of neighboring leads 206, 208 towards the other of the pair of neighboring leads 208, 206, is thinner than the leads themselves. Portions of the beams or elongate lugs connecting leads 206, 208 having variation in thickness are indicated in FIGS. 2A, 3, 4 and 5 by dotted lines. The outlines of lead frame 200 are indicated in FIGS. 2A, 3, 4 and 5 by solid lines. A plurality of beams connects the plurality of first leads 206 and the plurality of second leads 208 to fix them together in the inner lead areas 210. Herein, the term `inner lead area' may refer to the entirety of that portion, or area, of the lead which will, in the final packaged semiconductor device, be encapsulated in molding compound. Alternatively, it may refer to any part of the lead which is closer to the end of the lead proximal to the die pad than it is to the end of the lead distal from the die pad. Each of the beams 214 is connected between a pair of neighboring first lead 206 and second lead 208. For every beam 214, a first end of the beam, in an unbroken state, is connected with the first lead 206 and the second end of the beam is connected with the second lead 208. As will become apparent hereinunder, each beam has a thickness which is smaller than the full thickness of the lead frame. As will be more apparent hereunder, the beams will be broken during manufacture of the packaged semiconductor device. The beam may therefore also be referred to as a pair of lugs, or elongate lugs.

The aforementioned components of the lead frame 200, i.e., the die pad 202, the tie bar 204, the first leads 206 and the second leads 208, the beam214, and the outer frame 228 are made of electrically conductive material such as 42-alloy, or copper.

Next, one embodiment of fabricating the lead frame 200 will be described. The electrically conductive material is provided as a reel or tape. The reel is pressed to form the die pad 202, the tie bar 204, the first leads 206, the second leads 208 and the beams 214 integrally. Although the beams will eventually be broken to form elongate lugs 214, the parts of the lead frame are held in place, at this stage of the process, by a surrounding outer frame (not shown) outside the perimeter 228. The material may be 42-alloy. The thickness of the lead frame 200 may be about 0.127mm, or within a range of 0.12 to 0.14 mm, although other thicknesses are possible.

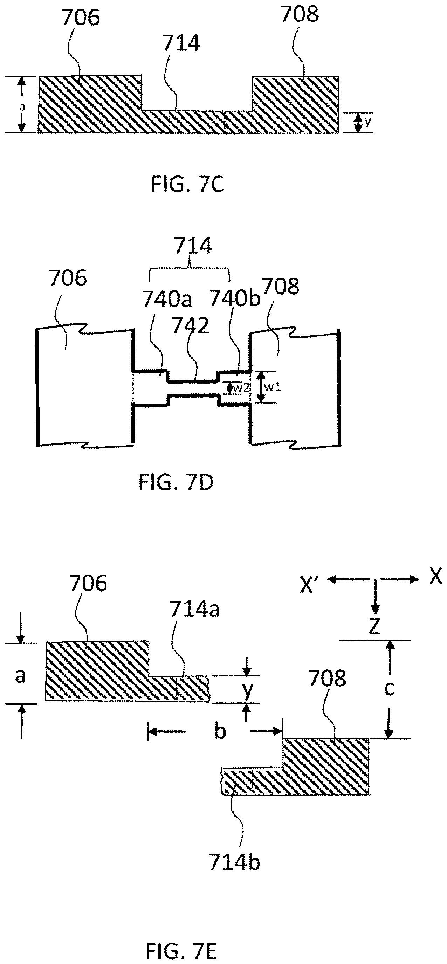

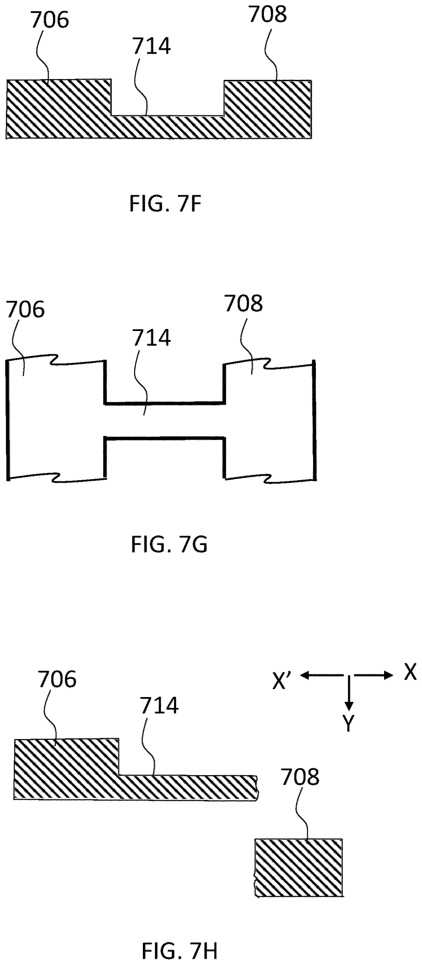

Regions of the beams are thinned, typically by etching, to form any one or more of a variety of different shapes (such as, without limitation, those shown, in profile, in the sideways sectional views of FIG.7C, FIG. 7D, FIG. 7E, and FIG. 7F). The profiles have in common, that they enable the beam, when placed under stress, to be broken, to result in at least one elongate lug with a thickness smaller than the full thickness of the lead frame. The thickness of the elongate lug may be, for example, less than 0.07mm.

The die pad 202 may be rectangular, and is typically square and may have a side length about 3mm although the present disclosure is not limited thereto. The inner area of the first leads 206 and the second leads 208 may have a width of about 0.3mm for a lead frame having 132 pins and about 0.25mm for a lead frame having 168 pins. Moreover, in a nonlimiting example application, the distance from the center of the die pad 202 to the ends of the lead proximal to the die pad of the first leads and the second leads may have a maximum of about 5mm for the 132 pins and about 6.2mm for the 168 pins.

Next, one embodiment of a process of fabricating a QFP by using the aforementioned lead frame 200 will be described with reference to FIG. 3 to FIG. 8.

First of all, as shown in FIG. 3, an adhesive 316 for adhering at least one semiconductor die (not shown) is applied to the die pad 302. Although the adhesive 316 only shows five blobs in FIG. 3, other number of blobs or other adhesive forms can be used to adhere the semiconductor die to the die pad.

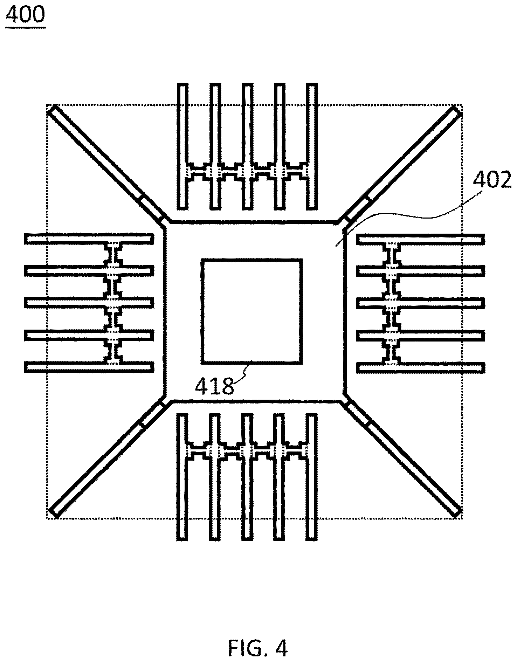

Next, as shown in FIG. 4, the semiconductor die 418 is positioned over an upper surface of the die pad 402 having the adhesive 316 (see FIG. 3) applied thereto.

Next, as shown in FIG. 5A-5B, the semiconductor die 518 is mounted on the die pad 502 and has its bonding pads 520 bonded to the inner lead areas 510 of first leads 506 and the second leads 508 by means of bond wires 522, which are typically of Au, to connect them electrically. Since both the first leads 506 and the second leads 208 are connected to the beams, the beams can reduce the influence on wire loop. In particular, the wire loops may include some stress, which could urge individual leads to move in either a vertical plane, a horizontal plane, or both. The stress could also urge individual leads to rotate. But since the leads are tied together, they are constrained, such that any such movement or rotation is reduced, or even eliminated.

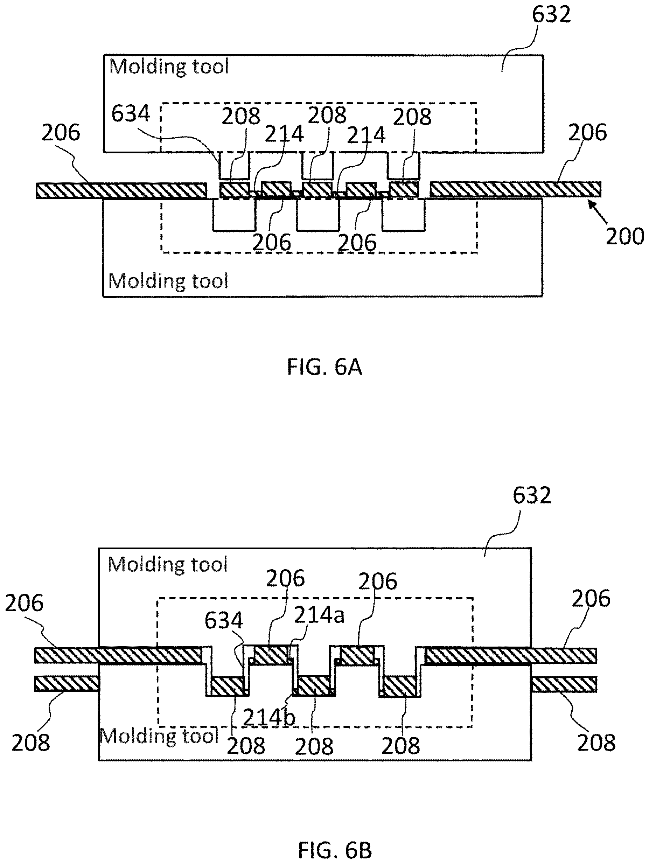

Next, the aforementioned lead frame 200 is fitted in a mold. FIG 6A shows a cross-section view of the lead frame of FIG. 2A along line C-C' at a first stage of forming the lead frame by a molding tool, at which time the molding tool 632 has been partially closed, so as to come into contact with the lead frame 200, but not sufficiently to start to deform any of the leads. FIG. 6B is a cross-section view showing a lead frame after lead deformation. As shown in FIG. 6A, 6B, by using a molding tool 632, a vertical offset between the plurality of second leads 208 and the plurality of first leads 206 in the vertical direction is formed, by deformation of at least one set of leads this. As illustrated in figure 6B, according to one or more embodiments, the first leads 206 are placed in a first plane, the second leads 208 are pressed downward and placed in a second plane. The second plane is offset from the first plane in a vertical direction. The plurality of second leads 208 are formed offset from the plurality of first leads in a vertical direction (shown in FIG.7E, FIG.7H). The beams 214 are broken in consequence of protruding portions 634 of the molding tool 632 applying pressure on the second leads 208. The skilled person will appreciate that in the embodiment shown in figure 6B, only the second set of leads are deformed. The entirety of the offset between the first and second sets of leads is thus produced by deformation of the second set of leads. However, according to other embodiments the offset may be generated or created by deforming both sets of leads. In particular, according to other embodiments one set of leads are deformed in a first vertical direction (such as upwards) whilst the other set of leads are deformed in the opposite vertical direction (in this case downwards).

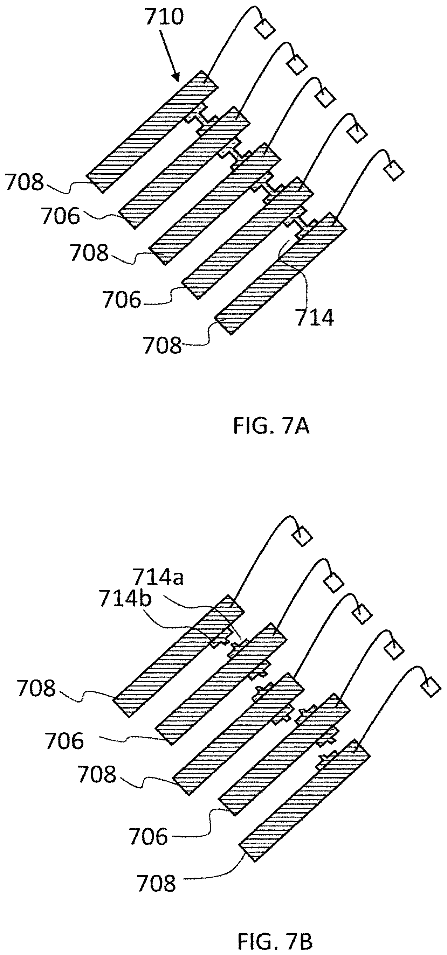

FIG. 7A is a schematic diagram showing the first leads, the second leads and the beams of the lead frame before they are formed and broken by the molding tool according to one embodiment of the present invention. As shown in FIG. 7A, the beams connect the inner lead areas 710 of the first leads 706 and the second leads 708 to hold the first leads 706 and the second leads 708 together. The inner areas 710 of the first leads and the second leads and the elongate lugs 714 are positioned in the same plane.

FIG. 7B is a schematic diagram of the first leads, the second leads and the elongate lugs after deformation according to one embodiment of the present invention. As shown in FIG. 7B, after deformation, each one of the beams (as shown in FIG. 7A) has been broken into two separated elongate lugs 714a, 714b, each of the elongate lugs extending away from the respective lead and towards the neighboring lead. Some of the elongate lugs extend in a direction 'x' (not shown) and the others of the elongate lugs extend in a direction 'X" which is opposite to the direction `x'.

The elongate lugs 714 are sheared or broken in the deforming process by the molding tool. As shown in FIG. 6B, the protruding portions 634 of the molding tool apply a (vertical) shearing force to the beam while pressure applied on the second leads 208, thereby shearing or breaking them, as the tool presses down on the second leads to form the second leads in a second plane.

Because the beams are broken (to form the elongate lugs) in the molding tool, the separated first leads and second leads are hard to move because they are clamped in the molding tool for further molding process.

Using the molding tool to separate the beams between the first leads and the second leads, only subsequent to the wire bonding process, helps to ensure that the lead frame does not suffer to such an extent from wire loop issues during the wire bonding.

The molding tool applies pressure on the lead frame in a vertical direction, then after lead deformation and beam breakage, the second leads 708 are formed in a second plane which is parallel to and below the first plane to create a gap, in a vertical direction. FIG. 7C is an enlarged sideways cross-section view of a pair of neighboring first lead, second lead and the elongate lug of the lead frame before molding of FIG. 2A along line B-B' according to one embodiment of the invention. Referring to FIG. 7C, a beam 714 has a thickness which is smaller than a full thickness of the lead frame. Giving the main body of the first lead 706 and the second lead 708 having a full thickness of "a", and a beam 714 connected between the first lead 706 and the second lead 708 has a thickness `y'. In this embodiment, since the lead frame is an etched lead frame to make the beam714 have smaller thickness than the full thickness 'a' of unetched portions of the lead frame, the thickness y should be y<a. In one embodiment, the thickness 'y' is less than one third of the thickness 'a'.

The skilled person will appreciate that in the embodiment shown in figure 6B, only the second set of leads are deformed. The entirety of the offset between the first and second sets of leads is thus produced by deformation of the second set of leads. However, according to other embodiments the offset may be generated or created by deforming both sets of leads. In particular, according to other embodiments one set of leads are deformed in a first vertical direction (such as upwards) whilst the other set of leads are deformed in the opposite vertical direction (in this case downwards).

FIG**.** 7D is a top plan view of a pair of neighboring first lead, second lead and the elongate lug of the lead frame before molding of FIG. 7C according to one embodiment of the invention. As shown in FIG. 7D, the beam 714 includes three parts 740a, 740b and 742. The first part 740a and the third part 740b may have the same width 'w1'. The second part 742 has a width `w2', which is smaller than the width 'w1'. In this embodiment, the first part 740a and the third part 740b have the same width. However, according to other embodiment, the first part 740a and the third part 740b may have different width. Since the second part 742 has a smaller width `w2' than the width 'w1'. The second part 742 is used to predetermine the breaking position in the process of separating the beam 714.

FIG.7E is an enlarged side view of the separated elongate lug parts, the pair of first leads and the second leads after the molding tool applying pressure on the second leads of FIG. C according to one embodiment of the invention. Referring to FIG. 7E, the leads 706 comprises an elongate lug 714a aligned in a horizontal plane with and extending towards a corresponding elongate lug 714b on a neighboring lead 708. Given a lead frame, the main body of the first lead 706 and the second lead 708 have a full thickness of 'a' , the distance between the main part of the first lead and the second lead is 'b' , the offset distance, in a vertical direction, between the first lead and the second lead is c. Then distance between the first part of the separated elongate lug part 14a and the second part of the separated elongate lug part 14b is c. In one non-limiting example, a=0.127 mm and b=0.3mm, and the distance c may be in the range of 0.3mm to 0.5mm.

The skilled person will appreciate that in the embodiment shown in figure 7D, the second part 742 of the beam 714 is in the middle of the beam 714. However, according to other embodiments, the second part 742 may be at any position of the beam 714. For example, the second part 742 may be close to the lead 706 and be far away from the lead 708 and vice versa. As shown in FIG. 7D, the second part 742 is in the form of a rectangular. However, according to other embodiment, the second part 742 may have any shapes in the horizontal plane. In a preferred embodiment, the second part 742 may have a predetermined location for further breaking where the predetermined location has a smallest width.

The skilled person will appreciate that in the embodiment shown in figures 7E, the beam 714 is broken in the middle of the second part 742. However, according to other embodiments, the beam 714 may be broken near the first part 740a or near the second part 740b.

FIG. 7F is an enlarged sideways sectional view of a pair of neighboring first lead, second lead and the beam of the lead frame before formed by the molding tool of FIG. 2A along line B-B' according to another embodiment of the invention. The difference between FIG. 7C and FIG. 7F is that the beam 714 of FIG. 7F has a uniform width as shown in FIG.7G. The thickness of the beam 714 is smaller than the full thickness of the lead frame.

FIG. 7G is a top plan view of a pair of neighboring first lead, second lead and the elongate lug of the lead frame before molding of FIG. 7F according to one embodiment of the invention. In this embodiment, as mentioned above, the beam 714 has a uniform width.

FIG.7H is an enlarged side view of the separated elongate lug parts, the pair of first leads and the second leads after the molding tool applying pressure on the second leads of FIG. 7F according to one embodiment of the invention. Referring to FIG. 7H, the beam was broken at the corner of lead 708. The lead 706 has an elongate lug and the lead 708 does not have an elongate lug. However, in other embodiment, the beam may be broken at the corner of lead 706 while the molding tool applies pressure one the lead 706. Then the lead 706 may not have an elongate lug although the lead 708 does an elongate lug.

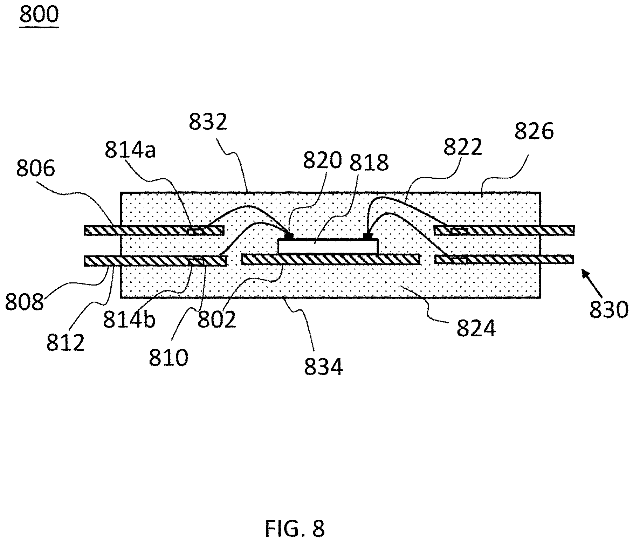

Returning now to a process flow in accordance with one or more embodiments. Next, referring to FIG. 8, a mold compound 824 is injected into the mold to cover the semiconductor die 818, the die pad 802, the bond wires 822, at least the inner lead areas 810 of the first leads 806 and the second leads 808, and the separated elongate lug parts 814a, 814b to define a package body 826.

The semiconductor package 800 comprises a top surface 832, a bottom surface 834, a vertical direction extending from the top surface 832 to the bottom surface 834, a semiconductor die 818, a lead frame 830, a die pad 802, a plurality of leads comprising a plurality of first leads 806 and a plurality of second leads 808 around the four sides of the die pad 802, spaced apart therefrom and electrically isolated therefrom, with spaces therebetween. Each of the pluralities of first leads 806 and second leads 808 has an inner lead area 810 proximate to the die pad 802 and an outer lead area 812 extending outwardly from the inner lead area 810. The inner lead areas of the plurality of first leads 806 are located in a first plane and the inner lead areas of the plurality of second leads 808 are located in a second plane in the vertical direction. Although, for some applications, the at least the distal ends of the outer area of the outer lead areas 812 of the first leads and the second leads may eventually be further deformed so as to lie in the same, or substantially the same, (horizontal) plane, in this embodiment, at this stage of the process, the plurality of first leads 806 extend outwardly from the package body 826 in a first plane, and the plurality of second leads 808 extent outwardly from the package body 826 in a second plane which is parallel to and below the first plane.

The semiconductor package 800 further includes at least one semiconductor die 818 attached to an upper surface of the die pad 802, such as with a die attach adhesive. Bonding pads 820 of the die pad 802 may be electrically connected with the inner lead areas of the first leads 806 and second leads 808 by bond wires 822. In one embodiment, a plurality of bond wires 822 which electrically connect bonding pads disposed on a top surface of the semiconductor die 818 with the plurality of first leads 806 and second leads 808. Molding compound 828 encapsulates the semiconductor die 818 and forms the package body 826. The molding compound 828 fills spaces between the first leads 806 and the second leads 808 and is in spaces separating the die pad 802 from the first leads 806 and the second leads 808. The semiconductor die 818 is attached to the first surface of the die pad 802. The plurality of second leads 808 are interleaved with the plurality of first leads 806.

As shown in FIG. 7E, 7H, at least one of each pair of neighboring first leads 806 and second leads 808 has elongate lugs 814 extending towards the other of the pair of neighboring leads. And each elongate lug remote from the lead has a thickness which is smaller than a full thickness of the lead frame. In one embodiment, each of the first leads comprises an elongate lug aligned in a horizontal plane with and extending towards a corresponding elongate lug on a neighboring lead and in a different plane as shown FIG. 7E. In other embodiments, the elongate lugs may have different shapes in a horizontal plane (not shown).

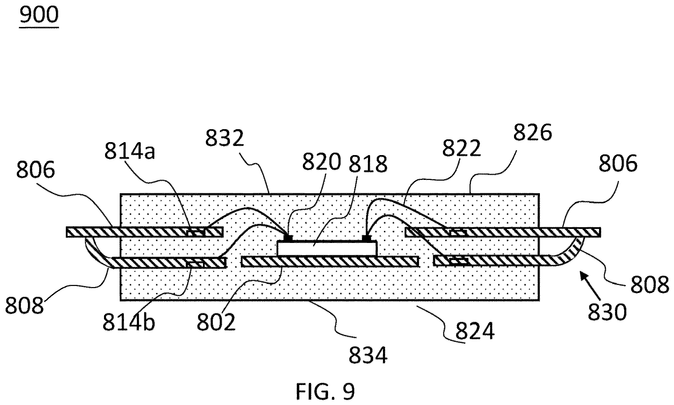

FIG. 9 is a conceptual sectional view of a QFP package 900 according to one embodiment of the present invention. In particular, it is a composite of a section through the packaged semiconductor device which includes a section through two of the plurality of first leads, and a section through the packaged semiconductor device which includes a section through two of the plurality of second leads. The skilled person will appreciate that in this embodiment, the inner part of each of the plurality of second leads is in the same horizontal plane as the die pad, and the inner part of each of plurality of first leads, is in a second horizontal plane, which is higher than that containing the die pad. In this embodiment, thus, the vertical offset between the plurality of first leads and plurality of second leads is created by deforming the first set of leads, rather than the second set of leads as described above with reference to FIG. 6B. After the package body is formed, the plurality of first leads 806 are formed into a Gull Wing shape (not shown), and the plurality of second leads 808 are formed into a J-lead shape. The first leads 806 in a Gull Wing shape are also known as Gull Wing Leads and the second leads 808 in a J-lead shape are also known as J-leads.

The use of the terms "a" and "an" and "the" and similar referents in the context of describing the subject matter (particularly in the context of the following claims) are to be construed to cover both the singular and the plural, unless otherwise indicated herein or clearly contradicted by context. Recitation of ranges of values herein are merely intended to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims as set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the application as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

## Claims

1. A semiconductor package having top and bottom surfaces and including a vertical direction extending from the top surface to the bottom surface, comprising:
a semiconductor die;
a lead frame comprising:
a die-pad having four sides, and
a plurality of leads having spaces therebetween and around the four sides of the die-pad, spaced apart therefrom and electrically isolated therefrom;
wherein the plurality of leads comprises a plurality of first leads and a plurality of second leads;
wherein inner lead areas of the plurality of second leads are interleaved with inner lead areas of the plurality of first leads, and offset therefrom in the vertical direction;
wherein the semiconductor die is attached to an upper surface of the die pad;
wherein at least one of any pair of neighboring leads comprises an elongate lug in the inner lead areas extending towards the other of the pair of neighboring leads, wherein each lug has a thickness which is smaller than a full thickness of the lead frame;
the semiconductor package further comprising molding compound encapsulating the semiconductor die and forming the semiconductor package, wherein the molding compound fills the spaces between the leads and fills spaces separating the die pad from the leads.

2. The semiconductor package according to claim 1, wherein each of the plurality of leads comprises an elongate lug aligned in a horizontal plane with and extending towards a corresponding elongate lug on a neighboring lead.

3. The semiconductor package according to claim 1, wherein each of the plurality of leads comprises only one elongate lug extending in a first direction towards a neighboring lead.

4. The semiconductor package according to any preceding claim, wherein the semiconductor package is a Quad Flat Package (QFP) package.

5. The semiconductor package accord to any preceding claim, wherein the thickness of each lug is less than one third of a full thickness of the lead frame.

6. The semiconductor package according to any of claims 1 to 4, wherein the elongate lugs have a uniform thickness which is smaller than a full thickness of the lead frame.

7. The semiconductor package according to any preceding claim, further comprising a plurality of bond wires which electrically connect bonding pads disposed on a top surface of the semiconductor die with respective ones of the plurality of first and second leads.

8. The semiconductor package according to any preceding claim, wherein the plurality of first leads are formed into a Gull Wing shape, and the plurality of second leads are formed into a J-lead shape.

9. The semiconductor package according to any preceding claim, wherein the thickness of the lead frame is 'a' of 0.127mm, a distance between the pair of neighboring first and second leads is `b' of 0.3mm, and a down-set `c' is in a range of 0.3mm to 0.5mm.

10. The semiconductor package according to any preceding claim, wherein the molding compound fills spaces below the second plurality of leads.

11. A method of manufacturing a packaged semiconductor device, comprising the steps of:
providing a lead frame comprising a die pad having four sides and a plurality of leads having spaces therebetween and around the four sides of the die pad, wherein the plurality of leads comprises a plurality of first leads and a plurality of second leads interleaved with the plurality of first leads, wherein neighboring leads of the plurality of leads are connected by a beam at inner lead areas of the first lead and the second lead;
mounting a semiconductor die on the die pad;
electrically connecting bonding pads disposed on a top surface of the semiconductor die with respective ones of the plurality of first and second leads;
using a molding tool, deforming the lead frame to: (i)break each of the beams to form a respective at least one elongate lug, wherein each broken lug has a thickness which is smaller than a full thickness of the lead frame;(ii)displace at least some of the leads to form a vertical offset between the plurality of second leads and the plurality of first leads; and
injecting molding compound into the molding tool to encapsulate the semiconductor die and form the package, wherein the molding compound fills spaces between the leads, and between the leads and the die-pad.

12. The method according to claim 11, wherein encapsulating the semiconductor die comprising deforming ends of plurality of first leads outside the package and ends of the plurality of second leads outside the package body, such that the ends of the leads are in the same horizontal plane.

13. The method according to claim 11 or 12, wherein breaking each of the beams comprises breaking it in a middle region of the lug to form each of the plurality of leads comprising an elongate lug aligned with and extending in a direction towards a corresponding elongate lug on a neighboring lead.

14. The method according to any of claims 11 to 13, wherein breaking each of the beams comprises breaking it at a position adjacent to a lead such that that lead comprises only one elongate lug extending in a first direction towards a neighboring lead.

15. The method according to any of claims 11 to 14, wherein the thickness of each lug is uniform.
